# EUROPEAN PATENT APPLICATION

(11) **EP 4 733 862 A1**
(43) Date of publication of application: **29.04.2026**
(21) Application number: 25209994.0
(22) Date of filing: 21.10.2025
(51) Int. Cl.: G04F 10/00

(54) **WIDE RANGE HIGH RESOLUTION TIME TO DIGITAL CONVERTER**

(30) Priority: 28.10.2024 IN 202441082188
(71) Applicant: NXP USA, Inc., Austin, TX 78735 (US)
(72) Inventor: Singh, Devesh Pratap, 5656AG Eindhoven (NL); Jain, Deependra Kumar, 5656AG Eindhoven (NL); Thakur, Akshay, 5656AG Eindhoven (NL)
(74) Representative: Miles, John Richard

(57) **Abstract**

A time to digital converter including multiple delay lines and an output adder. Each delay line includes multiple series-coupled buffers receiving a start signal, multiple latches each having an input coupled to an output of a buffer and an output providing one of multiple binary values in response to a stop signal, and an adder. Each adder adds the binary values from corresponding latches in response to the stop signal and provides a corresponding one of multiple digital output values. The output adder adds the digital output values from the delay lines and provides a digital output value indicative of a measured delay. The start and stop signals may be buffered to provide multiple start and stop signals each provided one of the delay lines. Each start signal may be delayed by one of multiple different delays. Select logic may combine multiple delay lines into a longer delay line group.

## Description

### BACKGROUND

### Field

The present disclosure relates in general to time to digital conversion, and more particularly to a wide range, high resolution time to digital converter formed by multiple delay lines and adders.

### Description Of The Related Art

A time to digital converter (TDC) has versatile use in clock and voltage measurement circuits. For measuring clock signals on a system-on-chip (SoC), a TDC might require wide input clock frequency range to handle a wide range of frequencies present on SoC, such as from the megahertz (MHz) frequency range to the gigahertz (GHz) frequency range. The resolution of the TDC should be on the order of about 1% of the period of any signal within the wide frequency range. Delay line-based TDCs, which are typically formed by a series of identical unit delays, are very commonly used to achieve high resolution. The delay line resolution is limited by the unit cell delay, such that the delay of each unit element should be very small in order to achieve the requisite high resolution.

In order to achieve lower unit delays, analog type or differential delay elements may be used, which, however, require larger power and area. Further advent of the fin field-effect transistor (finfet) process have benefitted digital delay units (with lower delays), yet the finfet process did not provide much benefit for analog cells. Although the digital delay unit cells did benefit from fast finfet processes, the reduced delay was still not sufficiently small to achieve the requisite high resolution. It is desired, for example, to achieve a delay on the order of only a few picoseconds (ps), which was not achieved using digital delay unit cells even when enhanced using fast finfet. Standard cell-based unit delay cells can achieve reasonable delays within a very compact area, but has a lower limit, especially at slow process-voltage-temperature (PVT) corners.

A Vernier delay line is a popular method of implementing a high resolution TDC. The variation across PVT corners, however, requires a relatively long delay line and significant mismatch among the unit cells has prohibited the ability to achieve high resolution. In addition, longer delay lines require longer wait times for conversion to complete. Furthermore, the wide frequency range of clock signals on an SoC would require an excessively long delay line.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified schematic and block diagram of a time to digital converter (TDC) implemented according to one embodiment.
FIG. 2 is a simplified timing diagram illustrating a measurement of a period of CLK_IN as a value TIN using the TDC of FIG. 1 implemented according to one embodiment.
FIG. 3 shows plots of 3 different transfer curves for different cases of operation of the TDC of FIG. 1 implemented according to one embodiment.
FIG. 4 is a schematic and block diagram of another TDC implemented according to another embodiment.
FIG. 5 is a schematic and block diagram of a TDC implemented according to yet another embodiment.
FIG. 6 is a schematic and block diagram of a TDC implemented according to still another embodiment.

### DETAILED DESCRIPTION

A time to digital converter (TDC) may be implemented as a sampled delay line. The resolution of the sampled delay line is limited by unit cell delay, which is a unit delay time (UDEL) of each of the buffers of the delay line. A single delay line may be sufficient for achieving relatively high resolution measurements when the unit delay time of each buffer is relatively small and when the delay line is sufficiently long compared to the measured time durations. Frequently, TDC accuracy is specified as percentage of input time being measured. As the measured time durations decrease, however, the resolution is reduced even when using ideal buffer cells with an idealized unit delay time with no mismatch or delay differences. A practical delay line is formed with non-ideal buffers with delay mismatches. A popular method for achieving a high resolution TDC is a Vernier delay line. The inevitable variation across process-voltage-temperature (PVT) corners, however, requires a large number of buffers in the delay line, yet mismatch among unit buffer cells prohibits achieving high resolution using a single delay line. In addition, a wide frequency range of clocks on a typical system-on-chip (SoC) requires a single delay line to be very long which requires long wait times for conversion to complete. For example, a typical SoC may need measurement ranging from several megahertz (MHz) to 1 to 2 gigahertz (GHz) range.

A TDC as described herein uses multiple parallel delay lines to exploit the stochastic properties of a sufficiently high number of parallel delay lines to achieve high resolution. The set of N substantially identical delay lines, each formed using M non-ideal buffers B1 - BM, exhibits different total delay due to random mismatch if there are a sufficiently large number of buffers in each delay line. Also, buffers may be inserted between the delay lines for driving start and stop signals without reducing resolution. In addition, multiple different offset delays may be inserted between the start signal and each of the multiple delay lines in order to achieve high resolution even for relatively short time durations, thereby increasing the frequency range of clock signals to be measured with the requisite resolution. Select logic may be included to combine the delay lines into groups to further widen the frequency range.

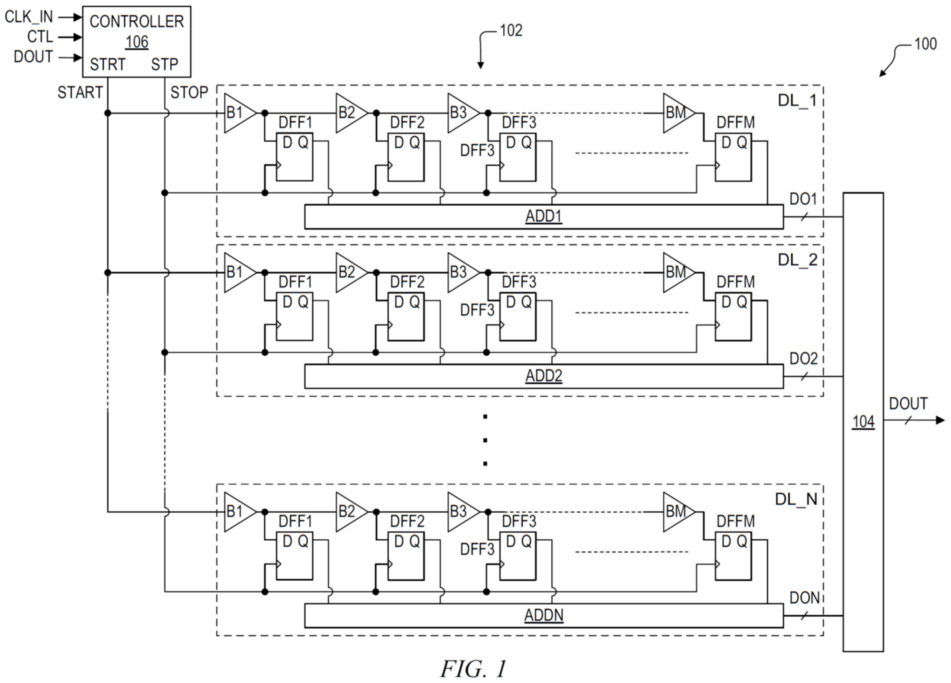

FIG. 1 is a simplified schematic and block diagram of a time to digital converter (TDC) 100 implemented according to one embodiment. The TDC 100 includes a set of N delay lines 102, individually labeled DL_1, DL_2, ..., DL_N (DL_1 - DL_N), an output digital adder 104 providing an output digital value DOUT, and a controller 106. Each delay line 102 may be implemented as a sampled delay line, although alternative delay line configurations are contemplated. Each delay line 102 includes a set of M series-coupled buffers B1, B2, B3, ..., BM (B1 - BM), a corresponding set of M D-type flip-flops (DFFs) DFF1, DFF2, DFF3, ..., DFFM (DFF1 - DFFM), and a corresponding one of a set of N digital adders, individually labeled ADD1, ADD2, ..., ADDN (ADD1 - ADDN), each outputting a corresponding one of N digital values DO1, DO2, ..., DON (DO1 - DON). Within each delay line, the output of B1 is coupled to the input of B2 at a first intermediate node, the output of B2 is coupled to the input of B3 at a second intermediate node, and so on. Each of the DFFs DFF1 - DFFM of each delay line 102 has a D input coupled to a corresponding one of the series of intermediate nodes formed by the set of buffers B1 - BM, and each has a Q output providing a binary value to a corresponding input of a corresponding one of the digital adders ADD1 - ADDN. Thus, within the first delay line DL_1, the D input of DFF1 is coupled to the output of B1 (and input of B2) and its Q output is provided to a first input of the adder ADD1, the D input of DFF2 is coupled to the output of B2 (and input of B3) and its Q output is provided to a second input of the adder ADD1, and so on.

It is noted that each DFF may generally be configured as any type of bistable multivibrator or "latch" having at least two stable digital states that can store information. Each DFF or latch is configured to change state by adjusting an input and applying one or more control inputs (e.g., set, reset, clear, clock, etc.). In the illustrated embodiments, each DFF latches its input to its output in response to a clock signal transition, although alternative configurations are possible and contemplated.

The controller 106 has a clock input receiving an input clock CLK_IN, a control input receiving one or more control signals CTL, a sample input receiving DOUT from the output digital adder 104, a start output STRT providing a start signal START to the input of each first buffer B1 of each of the delay lines 102, and a stop output STP providing a stop signal STOP to a clock input of each of the DFFs DFF1 - DFFN of each of the delay lines 102. The collective set of M binary values at the outputs of the DFFs DFF1 - DFFN of each of the delay lines 102 are added together by a corresponding one of the N adders ADD1 - ADDN. The digital values DO1 - DON of the adders ADD1 - ADDN are provided to N respective inputs of the output digital adder 104, which sums the digital values together to calculate DOUT.

In operation, a selected clock signal or other timing signal is provided as CLK_IN to the controller 106. Although CLK_IN may be a clock signal, it may also be a pulse signal or the like in which it is desired to measure the pulse duration. The CTL signals are used to control operation of the controller 106 for controlling the TDC 100 to measure one or more timing parameters of CLK_IN. For example, the TDC 100 may be used to measure the period or the duty cycle of a clock signal provided as CLK_IN, and multiple measurements of any given parameter may be made over time. At the beginning of a measurement cycle, the controller 106 may perform an initialization or reset phase by pulling START low for as long as necessary so that a logic zero propagates through each series of buffers B1 - BM and may pulse a reset signal (not shown) to clear each of the DFFs DFF1 - DFFM. The digital adders ADD1 - ADDN and the output adder 104 may be cleared or initialized in a similar manner.

After the initialization or reset phase, the controller 106 asserts the START signal high coincident with an operative edge of CLK_IN (e.g., rising edge or falling edge), and asserts the STOP signal high coincident with a subsequent operative edge of CLK_IN to measure the time duration between the operative pulses. For example, START may be asserted coincident with a rising edge of CLK_IN and STOP may be asserted coincident with the next rising edge of CLK_IN to measure the period of CLK_IN. Alternatively, START may be asserted coincident with a rising edge of CLK_IN and STOP may be asserted coincident with the next falling edge of CLK_IN to measure the high time duration of CLK_IN. Similarly, START may be asserted coincident with a falling edge of CLK_IN and STOP may be asserted coincident with the next rising edge of CLK_IN to measure the low time duration of CLK_IN. The high and low time durations may be used to determine a duty cycle of CLK_IN. For other time window measurement applications, the START transition coincides with beginning of a time window and the STOP transition coincides with end of the time window.

When START is asserted high, the rising edge propagates through the M buffers B1 - BM of each of the delay lines 102. In this manner, the intermediate nodes between the buffers are sequentially driven high. When STOP is asserted high, each of the DFFs DFF1 - DFFM are clocked so that the collective state of the intermediate nodes between the buffers B1 - BM are sampled by the DFFs and provided as corresponding binary signals to a corresponding one of the adders ADD1 - ADDN. Since, in this case, the intermediate nodes are reset to a logic 0 (logic low), the number of leading edge 1's (logic high) from the leftmost buffer B1 towards the right-most buffer BM represents the time duration between the assertions of START and STOP. For example, if the rising edge of START propagates only through the first 10 buffers of the first delay line DL_1, then the binary output of the DFFs of DL_1 is 111111111100000 ... 000b (in which an appended 'b' denotes a binary value). The corresponding adder ADD1 adds the total number of 1's of the delay line and outputs DO1 as a digital number. Assuming M = 128 for a total of 128 buffers B1 - B128, then DO1 may be represented as a 7-bit digital value. For the above example of 111111111100000 ... 000b, then DO1 = 0001010b, which is the equivalent of the decimal number 10. Each of the remaining delay lines DL_2 - DL_N operate in substantially the same manner, in which the rising edge of START propagates through each of the delay lines DL_1 - DL_N in parallel.

The output adder 104 sums the digital values DO1 - DON together and outputs the sum value as DOUT, which is shown provided back to the controller 106. For the example of M = 128 (series of 128 buffers in each delay line) and N = 32 for a total of 32 delay lines, then DOUT may be represented by at least a 12-bit value, such that 212 = 4,096. It is appreciated that the number of buffers in each delay line may be more than or less than 128, and that the number of delay lines may be more than or less than 32 in different embodiments. The output digital value DOUT effectively represents the delay or time duration between START and STOP.

It is appreciated that many variations are contemplated for using or otherwise implementing each of the delay lines 102. For example, although START is described as having a normal low state which transitions high to initiate a measurement, START may instead have a normal high state which transitions low to initiate a measurement. Also, although the non-inverting outputs of the DFFs DFF1 - DFFM are shown provided to the digital adders ADD1 - ADDN, the inverting output of the DFFs may instead be used. The digital adders ADD1 - ADDN may be configured to sample and detect leading 1's or leading 0's depending upon the particular configuration. In addition, the buffers are shown as non-inverting, but may instead be implemented as inverting buffers (e.g., inverters) when combined with using corresponding alternating inverting and non-inverting outputs of the DFFs.

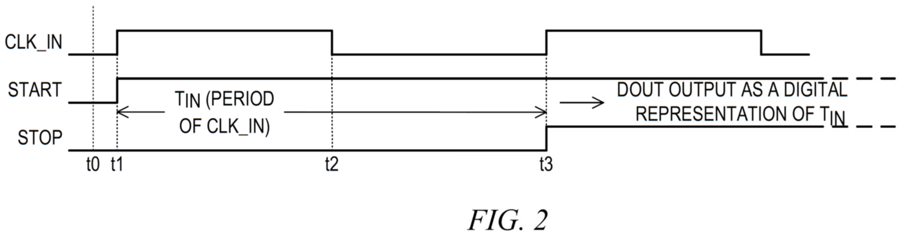

FIG. 2 is a simplified timing diagram illustrating a measurement of a period of CLK_IN as a value TIN using the TDC 100 implemented according to one embodiment. At an initial time t0, the TDC 100 has been reset or initialized and CLK_IN, START, and STOP are all low. At a subsequent time t1, CLK_IN goes high and the controller 106 is configured (and controlled) to assert START high coincident with the rising edge of CLK_IN. The rising edge propagates through the buffers of each of the delay lines until STOP is asserted. When CLK_IN next goes low at subsequent time t2, STOP remains low since the controller 106 is configured to measure one full period of CLK_IN. At subsequent time t3 when CLK_IN next goes high, STOP is asserted high by the controller 106 coincident therewith to measure the period of CLK_IN as the value TIN. In this case, the digital output value DOUT is provided to the controller 106 as a digital representation of TIN. The same measurement may be made multiple times over time to determine peak-to-peak jitter of CLK_IN. Alternative measurements may be made, such as asserting START at time t1 and STOP at time t2 for measuring the high time of CLK_IN, or asserting START at time t2 and STOP at time t3 for measuring the low time of CLK_IN, etc., in which the high and low times may be used for determining the duty cycle of CLK_IN. The same measurement may be made multiple times over time for finding an average and peak-to-peak variation in the duty cycle of CLK_IN.

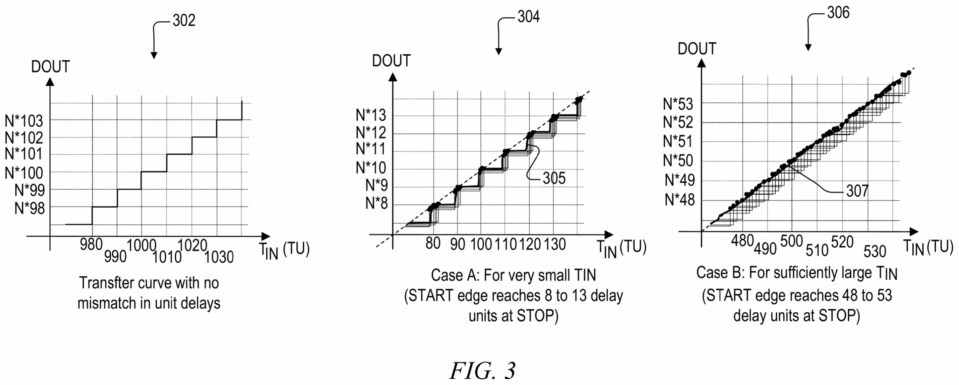

FIG. 3 shows plots of 3 different transfer curves 302, 304, and 306 for different cases of operation of the TDC 100 implemented according to one embodiment. Each diagram is a plot of DOUT versus measured TIN in response to application of a precise value of TIN, where DOUT is expressed in terms of the number of delay lines N multiplied by the number of transitioned buffers per case, and TIN is expressed in normalized time units (TU). Also, each buffer in each case has a delay of about 10TU. For the ideal case where there is no mismatch (curve 302), the buffer delay is assumed to be equal to 10TU for all buffers, whereas for the non-ideal cases (curves 304 and 306), the buffer delay has random variation with an average of 10TU. In one embodiment, each TU is one picosecond (ps) although alternative time units are contemplated. In each case, the actual TIN applied to the TDC 100 for each iteration is a precise multiple of 10TU, whereas the measured value TIN is the actual response time of the TDC 100.

The transfer curve 302 shows a case of the TDC 100 in which the applied TIN is swept from 980TU to 1030TU in TU increments and in which each buffer of each delay line is assumed to have an ideal delay of 10TU for purposes of comparison. For applied TIN = 980TU for the first pass, 98 buffers transition for each of N delay lines so that DO1 = DO2 = ... = DON = 98 (decimal) so that DOUT = N*98, where an asterisk (*) is used to denote multiplication. For applied TIN = 990TU for the second pass, 99 buffers transition for each of N delay lines so that DO1 = DO2 = ... = DON = 99 (decimal) so that DOUT = N*99. Operation is the same up to the last pass in which the applied TIN = 1030TU in which 103 buffers transition for each of N delay lines so that DO1 = DO2 = ... = DON = 103 (decimal) so that DOUT = N*103. For the ideal case, the resolution of each delay line of the TDC 100 is the same since each of the N delay lines have same time threshold values without variation.

The second transfer curve 304 shows a case of the TDC 100 in which the applied TIN is swept from 80TU to 130TU in which each buffer of each delay line has an average delay of about 10TU (e.g., 8 to 13 TUs). An average delay means that some buffers have less delay while others have greater delay due to random process mismatch, so that the measured delay shown as TIN varies from one delay to another. For applied TIN = 80TU for the first pass, DOUT averages at about N*8 and TIN varies from less than 80TU to greater than 80TU. For applied TIN = 90TU, DOUT averages about N*9 and TIN varies from less than 90TU to greater than 90TU. The same is true for each of the subsequent cases, showing variation of TIN for each of the applied TIN durations. In addition, an overall transfer curve 305 is plotted representing an average of the measured results. The first non-ideal transfer curve 304 represents relatively small input duration times in which only a small number of buffers are traversed by the START transition in each of N delay lines by the time STOP is asserted. In this case, the resulting variation may not be sufficient to achieve a desired resolution. Nonetheless, the overall transfer curve 305 does show a modest resolution improvement that may be achieved.

The third transfer curve 306 shows a case of the TDC 100 in which the applied TIN is swept from 480TU to 530TU and in which each buffer of each delay line has an average delay of about 10TU (e.g., 8 to 13 TUs). Again, average delay means that some buffers have less delay while others have greater delay. For applied TIN = 480TU, DOUT averages at about N*48. For applied TIN = 490TU, DOUT averages about N*49. The same is true for each of the subsequent cases, showing variation of DOUT for each of the applied TIN durations. In addition, an overall transfer curve 307 is plotted representing an average of the measured results. This second non-ideal case represents relatively large input duration times in which a significant number of buffers are traversed by START in each of the N delay lines by the time STOP is asserted. In this manner, the variation of the DOUT output of the N delay lines is sufficiently large so that the time threshold is spread over at least a single buffer delay or larger so that the resulting resolution is sufficiently high to achieve the desired level of accuracy.

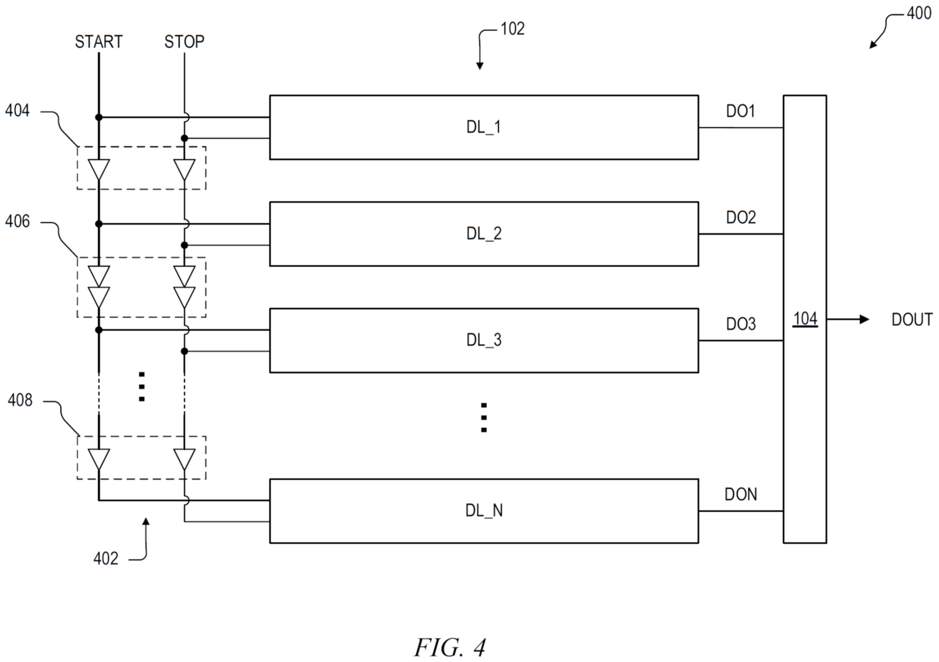

FIG. 4 is a schematic and block diagram of a TDC 400 implemented according to another embodiment. The TDC 400 is substantially similar to the TDC 100 in which similar components assume identical reference numerals. The TDC 400 includes the same set of N delay lines DL_1 - DL_N 102 providing the N digital values DO1 - DON to the output digital adder 104, which provides the output digital value DOUT. Although not explicitly shown, each of the delay lines DL_1 - DL_N includes the set of M buffers B1 - BM receiving the START signal, the series of M DFFs DFF1 - DFFM having clock inputs each receiving the STOP signal, and the set of N adders ADD1 - ADDN adding the outputs of the DFFs and providing the N digital values DO1 - DON to the output adder 104 in similar manner as previously described. The controller 106 or other similar controller developing the START and STOP signals may be included but is not shown simplify illustration.

The TDC 400 further includes a series of buffers 402 for buffering the START and STOP signals provided to each of the delay lines DL_1 - DL_N as shown. For example, a first set of buffers 404 may be provided to buffer the START and STOP signals provided to the delay line DL_2, another set of buffers 406 may be provided to buffer the START and STOP signals provided to the delay line DL_3, and so on up to a last set of buffers 408, which are provided to buffer the START and STOP signals provided to the last delay line DL_N. The series of buffers 402 provides a convenient way of buffering the START and STOP signals across an integrated circuit (IC) or semiconductor chip to ensure strength and integrity of the START and STOP control signals provided to each of the delay lines. Each set of buffers 404, 406, ..., 408 of the series of buffers 402 may include any number of series-coupled buffers suitable for maintaining electrical integrity of the signals. As shown, for example, the set of buffers 404 includes only one buffer each for buffering the START and STOP signals provided to DL_2, whereas the set of buffers 406 includes two buffers each for buffering the START and STOP signals provided to DL_3, and so on, while the last set of buffers 408 includes only one buffer each for buffering the START and STOP signals provided to DL_N. In general, any of the sets of buffers may include zero buffers, one buffer per START/STOP, or any number of series-coupled buffers for each of the START/STOP pair of control signals so long as the same number of buffers are provided for each of the START and STOP signals.

In this manner, it is appreciated that the START and STOP pair of control signals can reach different delay lines with different time delays so long as the START and STOP signals are delayed by about the same amount provided to any given delay line. Thus, only the START and STOP pair relative timing is important. Any fixed mismatch in delay of START side buffers with respect to STOP side buffers adds offset error in the measurement. Offset error can be removed by the application. It is appreciated that each buffer of the additional series of buffers 402 has a delay to delay each of the N digital values DO1 - DON provided to the output digital adder 104 by a different delay amount. Nonetheless, the output digital adder 104 is configured to wait until each of the digital values DO1 - DON has settled to a corresponding final value before adding them together to develop DOUT. The START and STOP signals need not have skew match among the different delay lines. In this manner, the START and STOP signals can have buffering among different delay lines allowing ease of implementation, so long as the same buffering is provided for both START and STOP signals provided to each respective delay line. In general, the START and STOP pair can be buffered serially in which there is no need for skew matched signals among different delay lines.

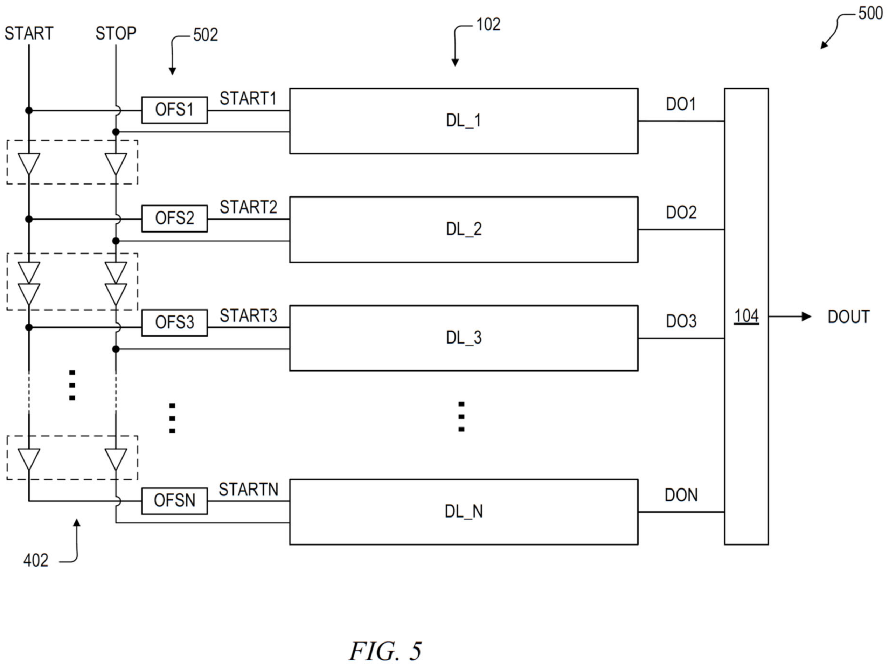

FIG. 5 is a schematic and block diagram of a TDC 500 implemented according to yet another embodiment. The TDC 500 is substantially similar to the TDC 400 in which similar components assume identical reference numerals. The TDC 500 includes the same set of N delay lines DL_1 - DL_N 102 providing the N digital values DO1 - DON to the output digital adder 104, which provides the output digital value DOUT. Although not explicitly shown, each of the delay lines DL_1 - DL_N includes the set of M buffers B1 - BM receiving the START signal, the series of M DFFs DFF1 - DFFM having clock inputs each receiving the STOP signal, and the set of N adders ADD1 - ADDN adding the outputs of the DFFs and providing the N digital values DO1 - DON to the output adder 104 in similar manner as previously described. The controller 106 or other similar controller developing the START and STOP signals may be included but is not shown simplify illustration. The TDC 500 may also include the series of buffers 402 for buffering the START and STOP signals as shown. Also, the output digital adder 104 is configured to wait until each of the digital values DO1 - DON has settled to a corresponding final value before adding them together to develop DOUT.

The TDC 500 further includes a series of offset delay buffers 502, individually shown as OFS1, OFS2, OFS3, ..., OFSN (OFS1 - OFSN) for delaying the START signal provided to each of the delay lines DL_1 - DL_N relative to the STOP signal. Thus, the first delay block OFS1 delays START to provide a START1 signal to the first delay line DL_1, the second delay block OFS2 delays START to provide a START2 signal to the second delay line DL_2, the third delay block OFS3 delays START to provide a START3 signal to the third delay line DL_3, and so on up to the last delay block OFSN, which delays START to provide a STARTN signal to the last delay line DL_N. As further described herein, the series of offset delay buffers 502 improves the resolution of the TDC 500 for relatively small input duration times such as the case for higher frequency clock signals.

Referring back to FIG. 3, the second transfer curve 304 shows the case in which the applied TIN is swept only from about 8 to 13 delay units (or buffers), such that the resulting variation may not be sufficient to achieve a desired resolution (e.g., when only about 20 buffers or less are toggled per delay line). The added series of offset delay buffers 502 simulates added mismatch between the delay lines to improve the overall resolution. In particular, the added series of offset delay buffers 502 shift the time threshold values of one or more of the delay lines differently, such that the individual delay line outputs toggle at different time instants, providing improved resolution of TDC 500.

Although it is possible to design any one or more of the offset delay buffers 502 with a delay that is less than the unit delay time (UDEL) of each of the buffers of the delay lines, the buffers B1 - BM are generally designed with as minimal delay as reasonably available. Instead, each of the offset delay buffers 502 are configured with a delay that is fractionally greater than UDEL. It is easier to incrementally increase the delay of a given buffer rather than using specialized manufacturing techniques or specialized cells or the like to decrease the delay.

To get sufficient improvement, the difference among added offset can be of the order of UDEL/2 or less. Also, although each of the offset delay buffers 502 may have a different delay (e.g., up to N different delays), incremental improvement may be achieved by having less than N different delay types (DTs) distributed among the delay lines. In fact, only two different delay types distributed among the delay lines (e.g., alternating delays between delay types DT1 and DT2) may provide a modest resolution improvement. Also, one of the delay types may be a zero delay which is implemented simply by not adding an offset delay block, so that some of the delay lines do not include an offset delay block 502. Adding 4 different types of offset values can be sufficient to improve resolution for some configurations, meaning that each delay line can have an offset of delay DT1 = 0, DT2 = UDEL + UDEL/4, DT3 = UDEL + 2*UDEL/4, DT4 = UDEL + 3*UDEL/4 distributed among the delay lines. To generate multiple values of offset, the same programmable delay cell with 4 (or more) different delay values can be used, or 4 (or more) different types of delay cells having four different delays, respectively can be used. The delay types may be distributed in a uniform manner, e.g., OFS1 = DT1, OFS2 = DT2, OFS3 = DT3, OFS4 = DT4, OFS5 = DT1, OFS6 = DT2, etc., or the different delay types may be randomly distributed among the N different delay lines. The averaging facilitated by the offset delay buffers 502 helps in reducing impact of flip-flop setup time mismatch (of the DFFs of each delay line), which can cause error of a conventional TDC using a single high-resolution delay line.

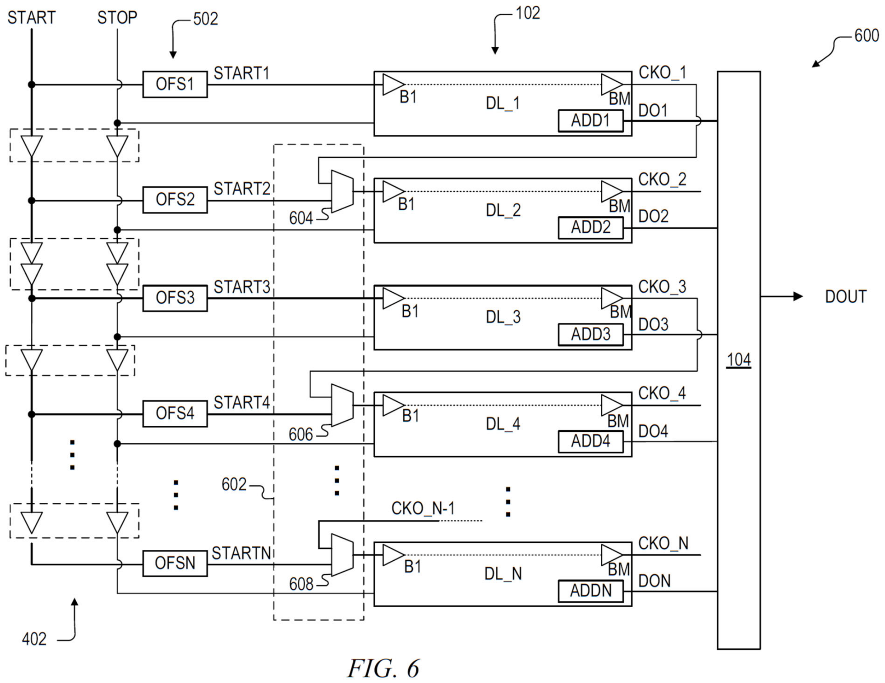

FIG. 6 is a schematic and block diagram of a TDC 600 implemented according to one embodiment. The TDC 600 is substantially similar to the TDC 500 in which similar components assume identical reference numerals. The TDC 600 includes the same set of N delay lines DL_1 - DL_N 102 providing the N digital values DO1 - DON to the output digital adder 104, which provides the output digital value DOUT. Again, each of the delay lines DL_1 - DL_N includes the set of M buffers B1 - BM receiving the START signal (in which only the first buffer B1 and last buffer BM are shown), the series of M DFFs DFF1 - DFFM having clock inputs each receiving the STOP signal, and the set of N adders ADD1 - ADDN adding the outputs of the DFFs and providing the N digital values DO1 - DON to the output adder 104 in similar manner as previously described. The controller 106 or other similar controller developing the START and STOP signals may be included but is not shown simplify illustration. The TDC 600 may also include the series of buffers 402 for buffering the START and STOP signals as shown. Also, the output digital adder 104 is configured to wait until each of the digital values DO1 - DON has settled to a corresponding final value before adding them together to develop DOUT. In addition, the TDC 600 further includes the series of offset delay buffers 502 for delaying the START signal provided to each of the delay lines DL_1 - DL_N relative to the STOP signal.

The TDC 600 further includes select logic 602 that may be controlled by the controller 106 or the like for combining one or more of the delay lines into each of one or more groups in which each delay line group forms an extended delay line. An extended delay line facilitates widening the frequency range of the TDC 600 for measuring longer durations of lower frequency clock inputs. In the illustrated embodiment, each of the delay lines DL_1, DL_2, DL_3, DL_4, ..., DL_N includes a final or last buffer BM providing a corresponding output clock CKO_1, CKO_2, CKO_3, CKO_4, ..., CKO_N, respectively. The select logic 602 includes a first multiplexer (MUX) 604 for selecting between the START2 signal normally provided to the second delay line DL_2 and the CKO_1 output clock from DL_1 for providing a selected signal to the input of the first buffer B1 of DL_2. When CKO_1 is selected, the delay lines DL_1 and DL_2 are combined into an extended delay line that is twice as long (2X) as each of the individual delay lines 102. In a similar manner, the select logic 602 includes a second MUX 606 for selecting between the START4 signal normally provided to the fourth delay line DL_4 and the CKO_3 output clock from DL_3 for providing a selected signal to the input of the first buffer B1 of DL_4. When CKO_3 is selected, the delay lines DL_3 and DL_4 are combined into an extended 2X delay line. Remaining pairs of delay lines are combined into 2X delay lines in a similar manner up to the last pair of delay lines DL_N-1 and DL_N, which are combined by a last MUX 608 selecting the output clock signal CKO_N-1 from the N-1st delay line DL_N-1.

Although the MUXes included in the select logic 602 illustrate doubling the delay lines into 2X long delay lines, additional MUXes may be included for tripling the delay lines into 3X length delay lines, quadrupling the delay lines into 4X delay lines, etc. It is noted that each delay line may include a significant number of buffers and corresponding DFFs, such as, for example, M = 128 for 128 buffers and 128 DFFs per delay line. If each of the delay lines were laid out in a linear fashion, then the last buffer BM may be significantly far from the first buffer B1 of the next delay line. Instead, each delay line may be laid out in the form of a U-shape, so that end point of delay line at BM arrives close to the starting point B1 of next delay line. A U-shape layout of the delay lines DL_1 - DL_N also facilitates a compact layout due to ease of signal routing within the delay line structure.

It is further noted that the same specification of relative accuracy applies for larger input times so that a larger absolute error is allowed when combining the delay lines into extended delay lines for measuring the larger input times. In other words, although the absolute accuracy is reduced for the extended delay lines, the relative accuracy is still sufficient since the input period being measured is correspondingly longer. The ability of combining delay lines into extended delay lines facilitates better circuit area utilization. It is noted that when the delay lines are combined for measuring longer durations, the controller 106 may bypass the offset delay buffers 502, such as programming or otherwise setting the delay of each offset delay block to zero delay. Generally, accuracy (resolution) is improved by using multiple delay lines placed in parallel when the input time is less than the overall delay of each delay line, in which a smaller delay line length is sufficient while finer resolution needed. The input time range may be increased by combining multiple delay lines to have larger length of delay lines when input time is large, in which longer delay lines are needed while resolution can be relaxed.

A TDC as described herein provides high resolution for a wide range of clock signal durations to be measured and optimizes circuit area layout. The TDC 100 illustrates using multiple parallel delay lines to exploit the stochastic properties of a sufficiently high number of parallel delay lines to achieve high resolution so long as a sufficient number of buffers (e.g., >20) are utilized in each delay line. The TDC 400 illustrates that the START and STOP signals may be equally buffered between the multiple parallel delay lines without reducing overall resolution. The TDC 500 illustrates that offset delay buffers with different delays may be used to delay the START signal by different amounts between the parallel delay lines to improve resolution for measuring higher frequency clock signals with shorter durations. The TDC 600 illustrates the select logic may be included to combine the delay lines into groups of extended delay lines for measuring lower frequency clock signals with higher durations without reducing the relative resolution. The controller 106 may be configured to program the TDC suitable for the duration to be measured. For example, the controller 106 may activate the offset delay buffers 502 and bypass the select logic 602 for measuring shorter durations, or may bypass the offset delay buffers 502 and program the select logic 602 to combine delay buffers into extended delay lines for measuring longer durations. The layout of the delay lines may be in a U-shape or the like to facilitate accuracy when grouping the delay lines.

The length of each delay line, generally denoted by M which is the number of buffers in each delay line, and the number of delay lines, generally denoted by N, may each be selected based on the desired frequency range of signals to be measured and by the desired resolution. In general, M is usually at least about 100, such as 128, although alternative lengths are contemplated. The number of delay lines N may be at least 8 or more, such as 16 or 32 or more depending upon the desired resolution.

A time to digital converter including multiple delay lines and an output adder. Each delay line includes multiple series-coupled buffers receiving a start signal, multiple latches each having an input coupled to an output of a buffer and an output providing one of multiple binary values in response to a stop signal, and an adder. Each adder adds the binary values from corresponding latches in response to the stop signal and provides a corresponding one of multiple digital output values. The output adder adds the digital output values from the delay lines and provides a digital output value indicative of a measured delay. The start and stop signals may be buffered to provide multiple start and stop signals each provided one of the delay lines. Each start signal may be delayed by one of multiple different delays. Select logic may combine multiple delay lines into a longer delay line group.

Aspects of the disclosure are defined in the accompanying claims. In a first aspect, there is provided a time to digital converter, comprising: a plurality of delay lines, each comprising: a plurality of buffers coupled in series including a first buffer having an input receiving a corresponding one of at least one start signal; a plurality of latches, each having an input coupled to an output of a corresponding one of the plurality of buffers, each having a clock input receiving a corresponding one of at least one stop signal, and each having an output providing a corresponding one of a plurality of binary values; and a plurality of adders, each configured to add a plurality of binary values of a corresponding one of the plurality of delay lines and providing a corresponding one of a plurality of digital output values; and an output adder configured to add the plurality of digital output values and having an output that provides a combined digital output value.

In some embodiments, the time to digital converter further comprises: a plurality of start buffers coupled in series having a first input receiving a first start signal and providing a plurality of second start signals, wherein each of the first start signal and the plurality of second start signals is provided to an input of a plurality of buffers of a corresponding one of the plurality of delay lines; and a plurality of stop buffers coupled in series having a first input receiving a first stop signal and providing a plurality of second stop signals, wherein a corresponding one of the first stop signal the plurality of second stop signals is provided to a clock input of each of a plurality of latches of a corresponding one of the plurality of delay lines.

In some embodiments, the time to digital converter further comprises: a plurality of offset delay buffers, each having a corresponding one of a plurality of different delays that are each greater than a unitary delay of each of the plurality of buffers of the plurality of delay lines, and each having an input receiving a corresponding one of the first start signal and the plurality of second start signals and having an output provided to an input of a plurality of buffers of a corresponding one of the plurality of delay lines.

In some embodiments, each of the plurality of buffers of each of the plurality of delay lines includes a last buffer providing a delay line output, the time to digital converter further comprising: select logic configured to selectively subdivide the plurality of delay lines into a plurality of groups in which each group includes at least two delay lines in which a delay line output of a preceding delay line is provided to an input of a next delay line.

In some embodiments, the time to digital converter further comprises: a plurality of offset delay buffers, each having a corresponding one of a plurality of different delays that are each greater than a unitary delay of each of the plurality of buffers of the plurality of delay lines, and each having an input receiving the at least one start signal and having an output provided to an input of a plurality of buffers of each of the plurality of delay lines.

In some embodiments, each of the plurality of buffers of each of the plurality of delay lines includes a last buffer providing a delay line output, the time to digital converter further comprising: select logic configured to selectively subdivide the plurality of delay lines into a plurality of groups in which each group includes at least two delay lines in which a delay line output of a preceding delay line is provided to an input of a next delay line.

In some embodiments, each of the plurality of buffers of each of the plurality of delay lines includes a last buffer providing a delay line output, the time to digital converter further comprising: select logic configured to selectively subdivide the plurality of delay lines into a plurality of groups in which each group includes at least two delay lines in which a delay line output of a preceding delay line is provided to an input of a next delay line.

In some embodiments, the preceding delay line in each of the plurality of groups is configured such that the buffer output of the preceding delay line is located within a predetermined close proximity of the input of the next delay line to minimize delay.

In some embodiments, a number of the plurality of delay lines is sufficient to obtain stochastic properties of the plurality of delay lines to achieve a predetermined high resolution level. In some embodiments, a number of the plurality of delay lines is at least 16 and wherein a number of the plurality of buffers of each of the plurality of delay lines is at least 100.

In a second aspect, there is provided a method of converting time to a digital value, comprising: providing a plurality of delay lines, each comprising: a plurality of buffers coupled in series including a first buffer having an input receiving a corresponding one of at least one start signal; and a plurality of latches, each having an input coupled to an output of a corresponding one of the plurality of buffers, each having a clock input receiving a corresponding one of at least one stop signal, and each having an output providing a corresponding one of a plurality of binary values; configuring a controller to assert a first start signal at the beginning of a time duration to measure and to assert a first stop signal and the end of the time duration; adding a plurality of binary values of a corresponding one of the plurality of delay lines and providing a corresponding one of a plurality of digital output values; and adding the plurality of digital output values and providing a combined digital output value.

In some embodiments, the method further comprising: buffering the first start signal for providing a plurality of second start signals in which each of the first start signal and the plurality of second start signals is provided to an input of a plurality of buffers of a corresponding one of the plurality of delay lines; and buffering the first stop signal for providing a plurality of second stop signals in which a corresponding one of the first stop signal and the plurality of second stop signals is provided to a clock input of each of a plurality of latches of a corresponding one of the plurality of delay lines.

In some embodiments, the method further comprising delaying each of the first start signal and the plurality of second start signals by a corresponding one of a plurality of different delays that are each greater than a unitary delay of each of the plurality of buffers of the plurality of delay lines.

In some embodiments, each of the plurality of buffers of each of the plurality of delay lines includes a last buffer providing a delay line output, the method further comprising: selectively subdividing the plurality of delay lines into a plurality of groups in which each group includes at least two delay lines in which a delay line output of a preceding delay line is provided to an input of a next delay line.

In some embodiments, the method further comprising delaying each of the at least one start signal by a corresponding one of a plurality of different delays that are each greater than a unitary delay of each of the plurality of buffers of the plurality of delay lines.

In some embodiments, each of the plurality of buffers of each of the plurality of delay lines includes a last buffer providing a delay line output, the method further comprising: selectively subdividing the plurality of delay lines into a plurality of groups in which each group includes at least two delay lines in which a delay line output of a preceding delay line is provided to an input of a next delay line.

In some embodiments, each of the plurality of buffers of each of the plurality of delay lines includes a last buffer providing a delay line output, the method further comprising: selectively subdividing the plurality of delay lines into a plurality of groups in which each group includes at least two delay lines in which a delay line output of a preceding delay line is provided to an input of a next delay line.

In some embodiments, the method further comprising configuring the preceding delay line in each of the plurality of groups such that the buffer output of the preceding delay line is located within a predetermined close proximity of the input of the next delay line to minimize delay.

In some embodiments, the providing a plurality of delay lines comprises providing a number of the plurality of delay lines sufficient to obtain stochastic properties of the plurality of delay lines to achieve a predetermined high resolution level. In some embodiments, the providing a plurality of delay lines comprises providing at least 16 delay lines each including at least at least 100 buffers.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A time to digital converter, comprising:
a plurality of delay lines, each comprising:
a plurality of buffers coupled in series including a first buffer having an input receiving a corresponding one of at least one start signal;
a plurality of latches, each having an input coupled to an output of a corresponding one of the plurality of buffers, each having a clock input receiving a corresponding one of at least one stop signal, and each having an output providing a corresponding one of a plurality of binary values; and
a plurality of adders, each configured to add a plurality of binary values of a corresponding one of the plurality of delay lines and providing a corresponding one of a plurality of digital output values; and
an output adder configured to add the plurality of digital output values and having an output that provides a combined digital output value.

2. The time to digital converter of claim 1, further comprising:
a plurality of start buffers coupled in series having a first input receiving a first start signal and providing a plurality of second start signals, wherein each of the first start signal and the plurality of second start signals is provided to an input of a plurality of buffers of a corresponding one of the plurality of delay lines; and
a plurality of stop buffers coupled in series having a first input receiving a first stop signal and providing a plurality of second stop signals, wherein a corresponding one of the first stop signal the plurality of second stop signals is provided to a clock input of each of a plurality of latches of a corresponding one of the plurality of delay lines.

3. The time to digital converter of claim 2, further comprising:
a plurality of offset delay buffers, each having a corresponding one of a plurality of different delays that are each greater than a unitary delay of each of the plurality of buffers of the plurality of delay lines, and each having an input receiving a corresponding one of the first start signal and the plurality of second start signals and having an output provided to an input of a plurality of buffers of a corresponding one of the plurality of delay lines.

4. The time to digital converter of claim 3, wherein each of the plurality of buffers of each of the plurality of delay lines includes a last buffer providing a delay line output, the time to digital converter further comprising:
select logic configured to selectively subdivide the plurality of delay lines into a plurality of groups in which each group includes at least two delay lines in which a delay line output of a preceding delay line is provided to an input of a next delay line.

5. The time to digital converter of any preceding claim, further comprising:
a plurality of offset delay buffers, each having a corresponding one of a plurality of different delays that are each greater than a unitary delay of each of the plurality of buffers of the plurality of delay lines, and each having an input receiving the at least one start signal and having an output provided to an input of a plurality of buffers of each of the plurality of delay lines.

6. The time to digital converter of claim 5, wherein each of the plurality of buffers of each of the plurality of delay lines includes a last buffer providing a delay line output, the time to digital converter further comprising:
select logic configured to selectively subdivide the plurality of delay lines into a plurality of groups in which each group includes at least two delay lines in which a delay line output of a preceding delay line is provided to an input of a next delay line.

7. The time to digital converter of any preceding claim, wherein each of the plurality of buffers of each of the plurality of delay lines includes a last buffer providing a delay line output, the time to digital converter further comprising:
select logic configured to selectively subdivide the plurality of delay lines into a plurality of groups in which each group includes at least two delay lines in which a delay line output of a preceding delay line is provided to an input of a next delay line.

8. The time to digital converter of claim 7, wherein the preceding delay line in each of the plurality of groups is configured such that the buffer output of the preceding delay line is located within a predetermined close proximity of the input of the next delay line to minimize delay.

9. The time to digital converter of any preceding claim, wherein a number of the plurality of delay lines is sufficient to obtain stochastic properties of the plurality of delay lines to achieve a predetermined high resolution level.

10. The time to digital converter of any preceding claim, wherein a number of the plurality of delay lines is at least 16 and wherein a number of the plurality of buffers of each of the plurality of delay lines is at least 100.

11. A method of converting time to a digital value, comprising:
providing a plurality of delay lines, each comprising:
a plurality of buffers coupled in series including a first buffer having an input receiving a corresponding one of at least one start signal; and
a plurality of latches, each having an input coupled to an output of a corresponding one of the plurality of buffers, each having a clock input receiving a corresponding one of at least one stop signal, and each having an output providing a corresponding one of a plurality of binary values;
configuring a controller to assert a first start signal at the beginning of a time duration to measure and to assert a first stop signal and the end of the time duration;
adding a plurality of binary values of a corresponding one of the plurality of delay lines and providing a corresponding one of a plurality of digital output values; and
adding the plurality of digital output values and providing a combined digital output value.

12. The method of claim 11, further comprising:
buffering the first start signal for providing a plurality of second start signals in which each of the first start signal and the plurality of second start signals is provided to an input of a plurality of buffers of a corresponding one of the plurality of delay lines; and
buffering the first stop signal for providing a plurality of second stop signals in which a corresponding one of the first stop signal and the plurality of second stop signals is provided to a clock input of each of a plurality of latches of a corresponding one of the plurality of delay lines.

13. The method of claim 12, further comprising delaying each of the first start signal and the plurality of second start signals by a corresponding one of a plurality of different delays that are each greater than a unitary delay of each of the plurality of buffers of the plurality of delay lines.

14. The method of claim 13, wherein each of the plurality of buffers of each of the plurality of delay lines includes a last buffer providing a delay line output, the method further comprising:
selectively subdividing the plurality of delay lines into a plurality of groups in which each group includes at least two delay lines in which a delay line output of a preceding delay line is provided to an input of a next delay line.

15. The method of any of claims 11 to 14, further comprising delaying each of the at least one start signal by a corresponding one of a plurality of different delays that are each greater than a unitary delay of each of the plurality of buffers of the plurality of delay lines.
